# EUROPEAN PATENT SPECIFICATION

(11) **EP 3 102 404 B1**
(45) Date of publication and mention of the grant of the patent: **30.06.2021**
(21) Application number: 15746452.0
(22) Date of filing: 04.02.2015
(51) Int. Cl.: C08J 5/00, C08J 5/24, C08J 5/04, B32B 5/12, B32B 5/28, B32B 7/06, C04B 35/83, B82Y 30/00, B82Y 40/00, B29C 70/62, B29C 70/08

(54) **METHOD FOR MANUFACTURE OF NANOSTRUCTURE REINFORCED COMPOSITES**
VERFAHREN ZUR HERSTELLUNG VON NANOSTRUKTURVERSTÄRKTE VERBUNDSTOFFEN
PROCÉDÉS DE FABRICATION DE COMPOSITES RENFORCÉS À NANOSTRUCTURES

(30) Priority: 04.02.2014 US 201461935445 P
(43) Date of publication of application: 14.12.2016
(73) Proprietor: NAWA America, Inc., Kettering OH 45420 (US)
(72) Inventor: WILLIAMS, Ryan, Cambridge, Massachusetts 02140 (US); DEGTIAROV, David, Cambridge, Massachusetts 02140 (US); GOULDSTONE, Christopher, Cambridge, Massachusetts 02140 (US); JAROSZ, Paul, Cambridge, Massachusetts 02140 (US); KENNEDY, Thomas J. III, Cambridge, Massachusetts 02140 (US)
(74) Representative: Schmidt, Martin Peter
(86) International application number: PCT/US2015/014399
(87) International publication number: WO 2015/120011

(56) References cited:
- EP-A1- 2 330 077
- WO-A1-2008/103221
- US-A1- 2003 096 104
- US-A1- 2004 097 635
- US-A1- 2005 167 647
- US-A1- 2007 004 081
- US-A1- 2008 075 954
- US-A1- 2008 086 564
- US-A1- 2008 286 564
- US-A1- 2009 117 363
- US-A1- 2009 266 477
- US-A1- 2010 196 695
- US-A1- 2011 192 233
- US-A1- 2012 164 903
- US-A1- 2013 029 089
- US-A1- 2013 071 565
- US-A1- 2013 101 495
- US-A1- 2013 216 811
- US-B2- 7 968 273
- US-B2- 8 257 678
- US-B2- 8 557 507

## Description

### BACKGROUND

The addition of nanostructures to fiber reinforced composites can enhance the mechanical, thermal, electrical, and electromagnetic properties of the composite article. In particular, carbon nanostructures such as vertically aligned carbon nanotubes (VACNTs) have been shown to enhance the material properties. The incorporation of micrometer (micron) scale fibers in aligned, woven, and randomly-oriented geometries allows control over the properties of the resulting material. Precise control over the degree of anisotropy in the composite material offers substantial design freedom to the composite fabricator. Similarly, the aligned, woven, or random orientation of nanostructures heavily influences the properties and anisotropy of the material.

The addition of nanostructured materials to a conventional fiber reinforced polymer composite results in what is called a hierarchical material. That is, a material where the macro, micro, and nanoscale arrangement of the constituent materials results in new and often surprising composite material properties. It is well understood that the physical and chemical properties of nanomaterials are often quite different than that of their micro- and macro-scale bulk counterparts. The addition of nanostructures to fiber reinforced composites in controlled geometries, alignments, and arrangements may provide for enhanced mechanical, thermal, electrical, and electromagnetic properties. However, incorporation of the nanostructures in controlled geometries remains a fabrication challenge. U.S. Publications No. 2008/0075954 and No. 2009/0117363, both by Wardle et al., discuss forming composite materials with aligned nanostructures at an interface. The publications do not discuss how the alignment or position of nanostructures may be maintained during an aggressive infusion process. US 2008/0286564 discloses carbon nanotube interlayer assemblies and methods of manufacturing same having features similar to the features described in the preamble of claim 1.

### SUMMARY

A method is proposed in claim 1 for producing a material that includes hybrid nanocomposite product, which includes a nanostructure array and a resin matrix contained among and/or around the nanostructure array. The product is placed in between layers of dry or resin-infused fiber composite to permit formation of a composite structure. The nanostructure array and/or the resin matrix may be disposed in an abutting relationship with other layers of a composite. The product can provide reinforcement of the composite in the z-direction. Transfer of resin into dry fiber forms may be provided when the product acts as a resin transfer medium. Nanostructure arrays with a resin matrix can be prepared to form a resin film composition. Methods are presented for infusing composites via resin-transfer molding (RTM), vacuum-assisted resin transfer molding (VARTM), resin film infusion (RFI), or injection molding using a resin matrix film that substantially maintains alignment and position of the nanostructure array during the infusion process.

According to some example configurations, an article is composed of a nanostructure array with at least some of the nanostructures having a length of at least 1 micrometer (micron) and/or a diameter less than 100 nm. The long axes of the nanostructures are substantially aligned relative to each other from top to bottom. A resin matrix is provided among, interior to the nanostructures themselves and/or around the nanostructure array. The nanostructures may have a density of at least 10⁸/cm².

The resin matrix may contain a nanoparticle that enhances the conductivity of resin matrix. The resin matrix may include a conducting polymer. The resin matrix may include an insulating polymer. The resin matrix may include a self-healing agent. The resin matrix may include a ceramic precursor. The matrix may include a ceramic material. The resin matrix may include a precursor to a graphite as in a carbon-carbon composite.

The resin matrix may be composed of one or more of a polythiophene, a polypyrrole, a polyacetylene, a polyphenylene, polypyrrole, poly(3,4-ethylenedioxythiophene) (PEDOT), poly(thiophene-3-acetic acid) (PTAA), or copolymers thereof; poly(tetrafluoroethylene) (TEFLON®), poly(glycidyl methacrylate), poly(maleic anhydride-alt-styrene), poly[ maleic anhydride-co-dimethyl acrylamide-co-di( ethylene glycol) divinyl ether], poly(furfuryl methacrylate), poly(vinyl pyrrolidone), poly(para-xylylene), poly(dimethylaminomethyl styrene), poly(propargyl methacrylate), poly(methacrylic acid-co-ethyl acrylate), poly(perfluoroalkyl ethyl methacrylate), poly(perfluorodecyl acrylate), poly(trivinyltrimethoxycyclotrisiloxane), poly(furfuryl methacrylate), poly(cyclohexyl methacryateco-ethylene glycol dimethacrylate), poly(pentafluorophenyl methacrylate), poly(pentafluorophenyl methacrylate co-ethylene glycol diacrylate), poly(methacrylic acid-co-ethylene glycol dimethacrylate), poly(methyl methacrylate) and/or poly(3,4-ethylenedioxythiophene) and/or common fiber reinforced composite polymer systems such as epoxides, phenolics, polyesters, polyurethanes, bis-maleimides, polyimides, and silicones.

The resin matrix may include a B-stage resin or partially cured resin, a hardener, cross-linking agent, coefficient of thermal expansion matching agent, erosion resistance agent, toughener, accelerator and/or flame retardant. The resin matrix may include a material that chemically reacts to form liquid or gaseous species that dissolves in or is removed from the final cured composite.

The article may be provided as a resin film and may be provided on at least one backing or release material associated with the nanostructure array that could be used for shipping and then removed. The article may be provided on at least one backing or release material associated with the nanostructure array that is not removed and contains a polymer that is used in the composite. The backing or release material may act as a support material and may include a monomer, a polymer, a fiber, or a metal. The nanostructure array may be arranged on a substrate, pre-preg, or semi-preg.

The nanostructure array may include nanotubes, nanofibers, nanowires or nanostructures. The volume fraction of the nanostructures within the article may be at least between 0.1% and 78%. The nanostructures may have an average diameter between 1 nm and 100 nm. The average distance between the nanostructures is between 5 nm and 100 nm.

The resin matrix may assist in maintaining alignment of the nanostructure array. The nanostructure array may be substantially perpendicular to the plane of a resin matrix material. The nanostructures may act or be caused to act or be used like tools within the matrix to permit selective absorption of specific frequencies and/or reduce the amount of energy used during curing. The nanostructures may be used to enhance heat transfer into or out of the curing composite. The nanostructures are connected to a power supply and used as electrical resistance heaters to assist the resin curing reaction. The nanostructures may be used to detect the state of the curing reaction and/or the endpoint. The nanostructures may be used to inspect the cured article for damage.

The nanostructure array with the resin matrix may include a polymeric material and can be placed atop or below a single layer of substrate, particularly a fiber layer, and/or placed in between two layers of substrate, pre-preg, semi-preg, or fiber. The nanostructure array may be grown or placed on a surface of a substrate, particularly a fiber layer, wherein the long axes of the nanostructures are substantially aligned and non-parallel to the substrate surface, to form an assembly of nanostructures having a thickness defined by the long axes of the nanostructures. The nanostructure array may be provided with a resin matrix over a portion of the surface area of the nanostructures. In some cases, the resin matrix is a uniform thickness. The nanostructure array may be a relatively large-area nanostructure array with a tailored thickness along the X and Y axes.

The alignment of the nanostructure array may be maintained while being incorporated into the resin matrix. The nanostructure array may be aligned perpendicular to a thin plane of the resin matrix. The resin matrix may have a thickness that deviates from a height of the nanostructure array less than 1000% or between 1% and 1000%.

The resin matrix may be heated, placed under vacuum and/or have pressure applied to assist in adhesion between the resin matrix and nanostructure array. The resin matrix may be infused into the nanostructure array through capillary action. The resin matrix may be arranged into a thin plane and/or introduced to the nanostructure array as an aerosol spray and/or with resin Chemical Vapor Deposition (CVD).

The article may be used to fabricate a composite where a nanostructure array with a resin matrix contained among and/or around the nanostructure array is placed in alternating layers with a sequence of fiber layers. The article may be provided as a resin film on a backing film or material, which backing film or material may be removed after adhesion of the resin film to an underlying substrate or fiber layer. The nanostructure array in resin matrix may be placed at all or some of the laminar interfaces or in selective areas of the interfaces. The nanostructure array in resin matrix may be joined to the surface of a fiber layer, as in a semi-preg. The composite may be fabricated by forming a sequence of semi-preg layers. The nanostructure array may be joined to fiber plies without a resin matrix. The nanostructure array may substantially penetrates one or more of the abutting fiber layers above or below, so as to fix or anchor the position and alignment of the nanostructures.

The assembled layer structure may be prepared for a resin infusion process such as resin transfer molding (RTM), vacuum assisted resin transfer molding (VARTM), resin film infusion (RFI), or injection molding. The assembly may be used with a configuration that may include tool plates (mold), preforms, distribution mediums, breather layers, bleeder layers, vacuum bags, peel plies, reinforcement layers, structured honeycombs, and/or sealant tapes. The assembly layer structure may be infused with resin, either perpendicular or parallel to the ply interfaces. The assembly may be heated to control the viscosity of the infusing resin and/or resin film. Vacuum and/or pressure may be applied to influence the flow of the resin, as in vacuum assisted resin transfer molding (VARTM).

The resin film provides mechanical stability to maintain alignment and positioning of the nanostructure array during the infusion process. The resin film may be composed of a resin the same or different from the infusing resin. The resin film may have a viscosity that is substantially higher than the infusing resin. The resin film with nanostructure array may serve as a source for all or some of the resin for the finished composite, as in a resin film infusion (RFI) process.

The infused assembly may be consolidated and cured under heat and/or positive or negative pressure using an autoclave, hot press, or other conventional method. The composite assembly may be heated at high temperature sufficient to form a ceramic material. The composite assembly may be heated in a reducing atmosphere to form a graphitic structure in a carbon-carbon composite.

### BRIEF DESCRIPTION OF THE DRAWINGS

The presently disclosed compositions and techniques are described in greater detail below with reference to the accompanying drawings, in which:
Fig. 1 is a depiction of a carbon nanotube array where a resin is infused on one side of the array;
Fig. 2 is a depiction of a carbon nanotube array where a resin matrix is infused in a planar center of a carbon nanotube array;
Fig. 3 is a depiction of a carbon nanotube array where resin matrix is infused in a planar center of a carbon nanotube array;
Fig. 4 is a depiction of a carbon nanotube array where the entire array is infused with a resin;
Fig. 5 is a depiction of a carbon nanotube array that is infused by a resin matrix beyond an extent of a length of the carbon nanotubes;
Fig. 6 is a depiction of a carbon nanotube array that is partially infused with a resin matrix and coupled with a pre-preg matrix;
Fig. 7 shows the process of incorporating a partially resin infused nanotube array that is incorporated between two sheets of dry fiber material;
Fig. 8 shows the process of incorporating a fully resin infused carbon nanotube array that is incorporated between two sheets of dry fiber material;
Fig. 9 is a depiction of a fully resin infused carbon nanotube array that is sandwiched between two layers of resin infused fiber pre-preg material; and
Fig. 10 is a depiction of the incorporation of a fully resin infused carbon nanotube array onto one side of a resin infused fiber pre-preg.

### DETAILED DESCRIPTION

Methods for the production of composite articles incorporating nanostructures in controlled arrangements, alignments, and geometries, as well as products using the methods are described herein. These methods and products are particularly well-suited for use with infusion-based processes for composite construction, including such infusion-based processes as resin-transfer molding (RTM), vacuum-assisted resin transfer molding (VARTM), and resin film infusion (RFI). Composite materials, including such items such as fibers, can be provided in unidirectional, woven, and randomly oriented composites, including fiber reinforced composites. Nanostructures can be introduced in controlled geometries to influence the underlying properties both of material used in composite construction as well as final composite products.

Aligned nanostructures have been shown to enhance the mechanical, thermal, electrical, and electromagnetic properties of composite materials. In particular, the placement of vertically aligned carbon nanotubes at the inter-laminar ply interfaces of carbon fiber reinforced polymer composites has demonstrated substantial enhancement of the mechanical toughness, as well as enhancement of other mechanical properties. The placement of aligned carbon nanostructures at ply interfaces has also been demonstrated in glass, alumina, basalt, and other fiber materials in fiber reinforced polymer composites. Additionally, the placement of these aligned nanostructures has been shown to increase the thermal and electrical conductivity of the composite, enabling them to be used as multifunctional materials, e.g. a mechanical structure that also conducts electricity. These multifunctional properties can be used for applications such as structural health monitoring, de-icing heaters, out-of-autoclave polymer curing, polymer cure detection, embedded electrical heaters, electromagnetic signature modification, and manufacturing quality control and parts inspection.

The placement of aligned nanostructures in composite materials has been demonstrated primarily with pre-preg material, that is, material such as fibers that is impregnated with thermoset or thermoplastic polymer resin formed in sheets. The sheets typically have a backing paper on one or both sides. The sheets can be cut into shapes and used to form a composite article by laying successive layers with different orientations (e.g. 0°, +/-45°, 90°) to construct the final part. The part is then heated, which causes the resin to flow as a liquid resin and cure into a solid polymer, typically through a cross-linking reaction for thermosets. The heating process can be combined with mechanical or fluid pressure in a mechanical press, vacuum oven, or autoclave.

The term pre-preg describes pre-impregnated composite fibers where a material, such as epoxy or unsaturated polyester, is already present. The resin matrix is only partially cured to allow easy handling. This configuration is called B-Stage material and typically requires cold storage to prevent complete curing although room temperature pre-pregs have been developed. Composite structures built of pre-pregs will mostly require an oven or autoclave to come to a final cure. In pre-preg based methods, the tacky resin allows the aligned nanostructures to adhere to the pre-preg, maintaining their position at the ply interface, preserving their alignment, and serving as a source of resin to fully encapsulate the aligned nanostructures. During consolidation and curing of the composite part, the flowing resin travels relatively short distances, on the order of less than the ply thickness, because the plies are already impregnated with resin.

However, many composite structures are not manufactured using pre-preg materials. Infusion-based methods such resin-transfer molding (RTM), vacuum-assisted resin transfer molding (VARTM), and resin film infusion (RFI) are widely used in the composite construction industry. These methods present a significant challenge for the incorporation of sheets of aligned nanostructures at the ply interfaces. Typically, infusion-based methods use fiber layers that are laid up dry with no resin. In RTM and VARTM, the layer structure is typically encapsulated ("bagged") in polymer film and resin is allowed to flow and infuse through the dry fibers. The whole structure is then baked to cure or set the polymer. In resin film infusion (RFI), the dry fiber layers are alternated with polymer sheets of resin film. Heat is applied and the resin begins to soften and flow through the dry fiber layers to form the consolidated composite. In another variation, these resin films may be bonded to the surface sheets of fiber in a product format called semi-preg.

The above-described infusion-based composite molding techniques present a challenge when aligned nanostructures are desired at the ply interfaces for mechanical reinforcement or other property enhancement. For example, the dry aligned nanostructures are difficult to join with the dry fiber layers. The aligned nanostructures may be placed at the interface, but there is little to no adhesion of the dry nanostructures to a dry fiber layer. It is furthermore difficult to maintain the coherence, alignment, and positioning of the aligned nanostructures. With infusion-based methods the resin travels substantially through the entire volume of the composite, from an inlet to an outlet. The bulk flow of the resin typically displaces the nanostructures, moving them away from ply interfaces and disrupting their alignment. The accumulation and entanglement of the nanostructures within the resin may also negatively impact the flow pattern and lower the viscosity of the resin resulting in nonuniform distribution of both the resin and the nanostructures.

The methods and products discussed herein provide for aligned nanostructures that can be integrated with infusion-based composite construction methods while preserving the alignment and placement of the nanostructures. In an example embodiment, aligned nanostructure films, here, sheets of VACNTs, are joined to a sheet of resin film. The resin film may be a thermoset or thermoplastic material. The aligned nanostructure films may be provided on a particular carrier material such as a metal foil, polymer film, or paper backing. The joining may be accomplished by heating the resin film and/or applying both vacuum and/or pressure to increase the tackiness of the resin to enhance transfer of the aligned nanostructure film. The thickness of this resulting film may be less than, equal to, or substantially greater than the thickness (height) of the aligned nanostructure film. The result is a film of aligned nanostructures partially or fully embedded within the polymer. The aligned nanostructure resin films may be applied by being placed in alternating layers or patterns with dry fiber layers. The aligned nanostructure resin films need not be placed at every ply interface and may be placed selectively at different interfaces or in limited areas of particular interfaces. The aligned nanostructure resin films may be tapes, sheets, or patches of material. The aligned nanostructure resin films may be partially bonded to layers of dry fiber in a semi-preg configuration.

The VACNT material may be pretreated with a surface tension modifying material or a compatibilizing material, such as maleic anhydride, so that the resin flows more easily into the VACNT forest. The VACNT forest may also be functionalized with an organic or inorganic moiety to improve the adhesion of the VACNT forest to the resin matrix.

In an example RTM or VARTM compatible configuration, one or more aligned nanostructure resin films may be placed within a dry fiber stack. The aligned nanostructure resin films may be connected to each other and/or the dry fibers or dry fiber stack in a conventional configuration, which may include tool plates (mold), preforms, distribution mediums, breather layers, bleeder layers, vacuum bags, peel plies, reinforcement layers, structured honeycombs, and sealant tapes. There may be one or more inlets and outlets for the infused resin. The infused resin may be identical, similar, or different in composition to the resin film. In some example embodiments, the aligned nanostructure resin film may include a high viscosity resin, while the infused resin may have a lower viscosity to permit the infused resin to flow around the aligned nanostructures. In some example embodiments, the aligned nanostructure resin film may include a low viscosity resin, while the infused resin may have a higher viscosity to permit the infused resin to flow around and through the aligned nanostructures. Management of the relative viscosity of the two films allows for design of infusion methods that maintain the alignment and positioning of the nanostructures. Upon application of heat, pressure, and/or vacuum, the infused resin flows through the composite structure, filling the bulk of the volume with resin and encapsulating both the fibers and the aligned nanostructures. The resin in the resin film maintains the alignment and position of the aligned nanostructures during the relatively aggressive infusion process. The direction of the bulk resin flow may be parallel, perpendicular, or randomly oriented to the alignment direction of the nanostructures. In some embodiments, the bulk resin flow is parallel to the direction of the nanostructures to minimize forces that may disrupt the position and alignment of the nanostructures.

In a resin film infusion (RFI) configuration, the aligned nanostructures resin films are the source for all or most of the resin in the final composite structure. A composite layer, or ply, that includes the aligned nanostructures resin films may be placed in a configuration that may include tool plates (mold), preforms, distribution mediums, breather layers, bleeder layers, vacuum bags, peel plies, reinforcement layers, structured honeycombs, and sealant tapes. The entire assembly is heated, allowing the resin to flow and encapsulate both the fiber and aligned nanostructure layers. The alignment and placement of the aligned nanostructures is wholly or substantially maintained during the heating, curing, and consolidation process

In any of the infusion methods, once the composite structure has been impregnated with resin, the entire assembly may be consolidated and cured in an autoclave, hot press, or other conventional approach. In another configuration, the nanostructures layers are connected to an external power source and used as embedded heaters to heat the composite part and cure the resin, either with or without the assistance of an autoclave, hot press, cold press, or other consolidation method. The resin material may utilize a single or dual cure polymerization process for thermoset materials. For a thermoplastic resin material, the heating process may encourage the resin to flow and consolidate with or without initiating a reaction.

The resin matrix may be composed of a polythiophene, a polypyrrole, a polyacetylene, a polyphenylene, polypyrrole, poly(3,4-ethylenedioxythiophene) (PEDOT), poly(thiophene-3-acetic acid) (PTAA), or copolymers thereof. In addition, or alternatively or in combination, the resin matrix may be composed of at least one of poly(tetrafluoroethylene) (TEFLON®), poly(glycidyl methacrylate), poly(maleic anhydride-alt-styrene), poly[ maleic anhydride-co-dimethyl acrylamide-co-di( ethylene glycol) divinyl ether], poly(furfuryl methacrylate), poly(vinyl pyrrolidone), poly(para-xylylene), poly(dimethylaminomethyl styrene), poly(propargyl methacrylate), poly(methacrylic acid-co-ethyl acrylate), poly(perfluoroalkyl ethyl methacrylate), poly(perfluorodecyl acrylate), poly(trivinyltrimethoxycyclotrisiloxane), poly(furfuryl methacrylate), poly(cyclohexyl methacryateco-ethylene glycol dimethacrylate), poly(pentafluorophenyl methacrylate), poly(pentafluorophenyl methacrylate co-ethylene glycol diacrylate), poly(methacrylic acid-co-ethylene glycol dimethacrylate), poly(methyl methacrylate) and/or poly(3,4-ethylenedioxythiophene).

In an example embodiment, nanostructure arrays or vertically aligned carbon nanotubes (VACNTs) or VACNT arrays or nano-fiber arrays are produced in a continuous process at ambient or near ambient pressure. In such an embodiment, nanostructure arrays with or without a resin matrix may be transferred to a second substrate such that the nanostructure arrays, if without the resin matrix, would have a resin matrix form added in a second processing step.

According to some embodiments, a resin is introduced into the nanostructure arrays such that a cohesive sheet is formed of a resin matrix on a transfer substrate for shipping and of composites. The transfer substrate may be a release paper that has been treated with a low energy coating, like a polydimethyl siloxane, to facilitate the release and subsequent incorporation of the resin / VACNT matrix into a composite structure. The resin may be an epoxy resin such as a b-staged bis-phenol A / epichlorohydrin with a blocked polyamide or polyamine.

In some configurations, the matrix material could be a ceramic precursor such as a sol-gel precursor. In these and previous configurations, the composite structure may be heated at a high temperature to form a ceramic material or in a high-temperature reducing atmosphere to pyrolize the resin matrix, as in a carbon-carbon composite. The incorporation of the resin matrix into the carbon nanotube array may be performed by various processes that include lamination, dipping, flow coating, spraying, gravure, vapor deposition and the like.

In some configurations, the matrix material for the nanostructures may be a material that is commonly formulated in pre-preg or resin films, such as hardeners, cross-linking agents, coefficient of thermal expansion matching agents, erosion resistance agents, tougheners, accelerators, or flame retardants. In some configurations, the matrix material for the nanostructures may be a material that chemically reacts and forms a liquid solvent or gaseous species that is subsequently dissolved within or removed from the final cured composite.

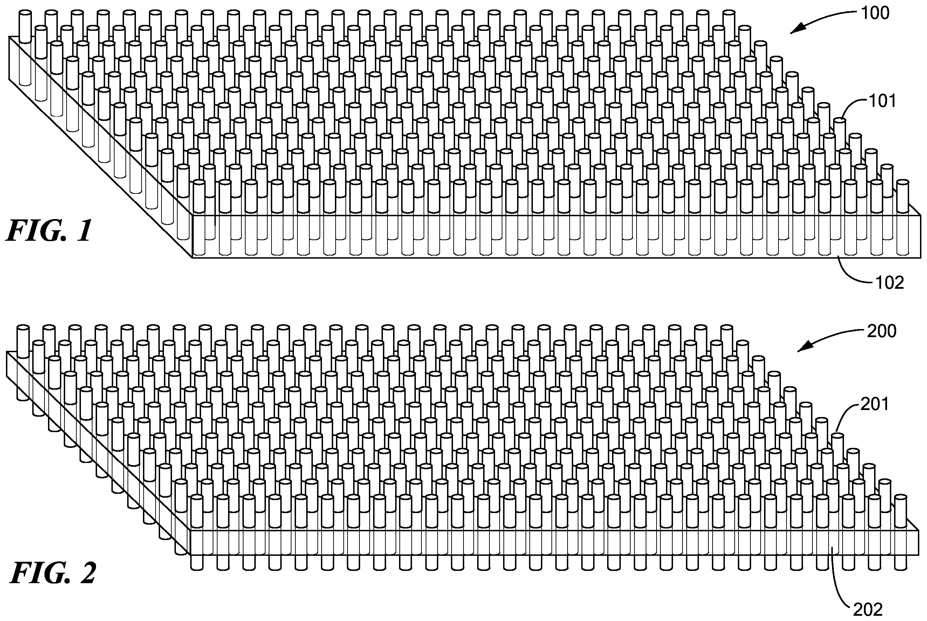

Fig. 1 is a view of a composite 100 that is comprised of a resin matrix form 102 at a base of a nanostructure array 101. Resin matrix 102 may also be positioned at a top of nanostructure array 101, or composite 100 may be rotated 180 degrees. It should be understood that any orientation of composite 100 is possible, where resin matrix 102 extends from an end of the nanostructures in nanostructure array 101 to a substantially uniform length along the nanostructures. Resin matrix form 102 can be 1%-99.9999999% of the height of nanostructure array 101. Nanostructure array 101 is between 1 micrometer (micron) and 2000 micrometers (microns) in height.

Fig. 2 is a view of a composite 200 comprised of a resin matrix form 202 between a top and a base of a nanostructure array 201. Resin matrix form 202 can be 50%-99% of the height of nanostructure array 201. Ends of nanostructure array 201 are not covered by resin matrix form 202, but are rather exposed. Nanostructure array 201 is between 1 micrometer (micron) and 2000 micrometers (microns) in height.

is a view of a composite 300 comprised of a resin matrix form 302 between a top and a base of a nanostructure array 301. Resin matrix form 302 can be 1%-50% of the height of nanostructure array 301. Ends of nanostructure array 301 are not covered by resin matrix form 302, but are rather exposed. Nanostructure array 301 is between 1 micrometer (micron) and 2000 micrometers (microns) in height.

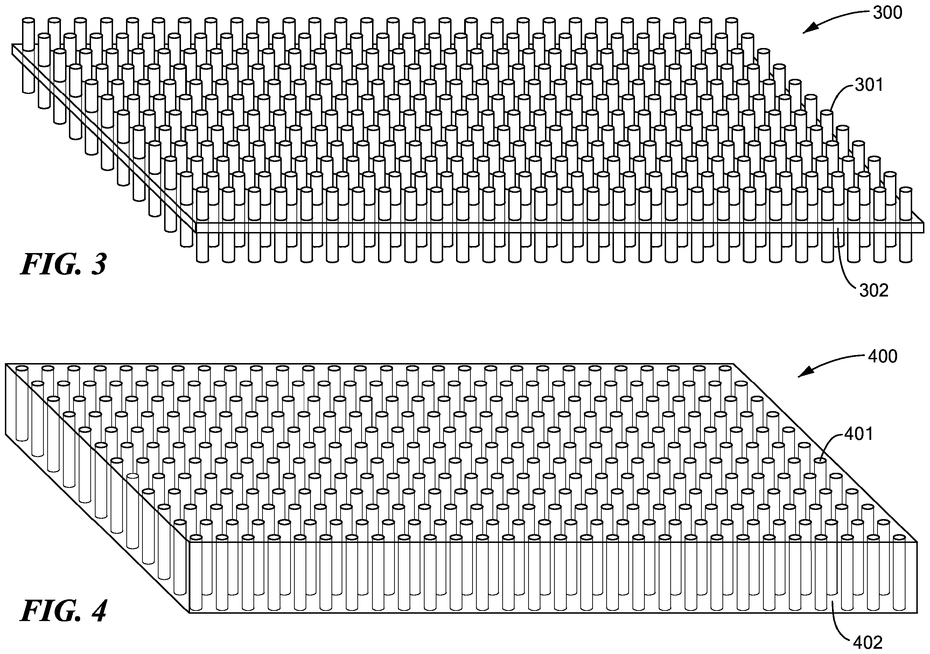

Fig. 4 is a view of a composite 400 comprised of a resin matrix form 402 entirely encapsulating a nanostructure array 401 and is at least 100% of the height of nanostructure array 401. Accordingly, resin matrix form 402 has at least a height and position that permits resin matrix form 402 to extend from end to end of the nanostructures in nanostructure array 401. Nanostructure array 401 is between 1 micrometer (micron) and 2000 micrometers (microns) in height.

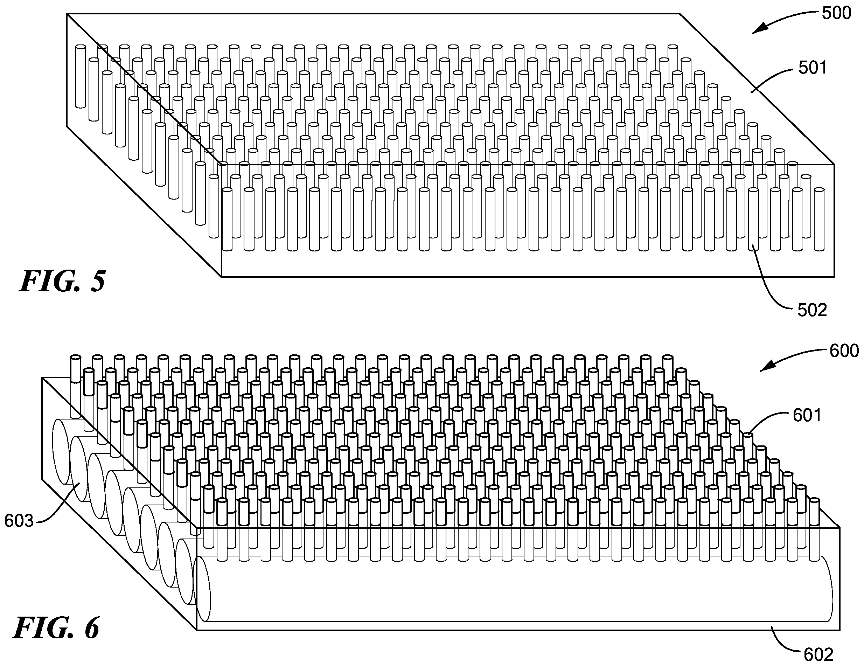

Fig. 5 is a view of a composite 500 comprised of a resin matrix form 501 entirely encapsulating a nanostructure array 502 and is from 100% to 500% of the height of nanostructure array 502. Thus, resin matrix form 501 extends beyond at least one end of the nanostructures, and may extend beyond both ends of the nanostructures in nanostructures array 502. Nanostructure array 502 is between 1 micrometer (micron) and 2000 micrometers (microns) in height.

Fig. 6 is a view of a composite 600 comprised of a nanostructure array 601 on top of a resin impregnated fiber layer 603 also called "pre-preg." Nanostructure array 601 is between 1 micrometer (micron) and 2000 micrometers (microns) in height and resin matrix 602 is between 100% and 500% of the height of the nanostructure array. Ends of the nanostructures in nanostructure array 601 may be covered by resin matrix 602, or may be exposed on one or more ends.

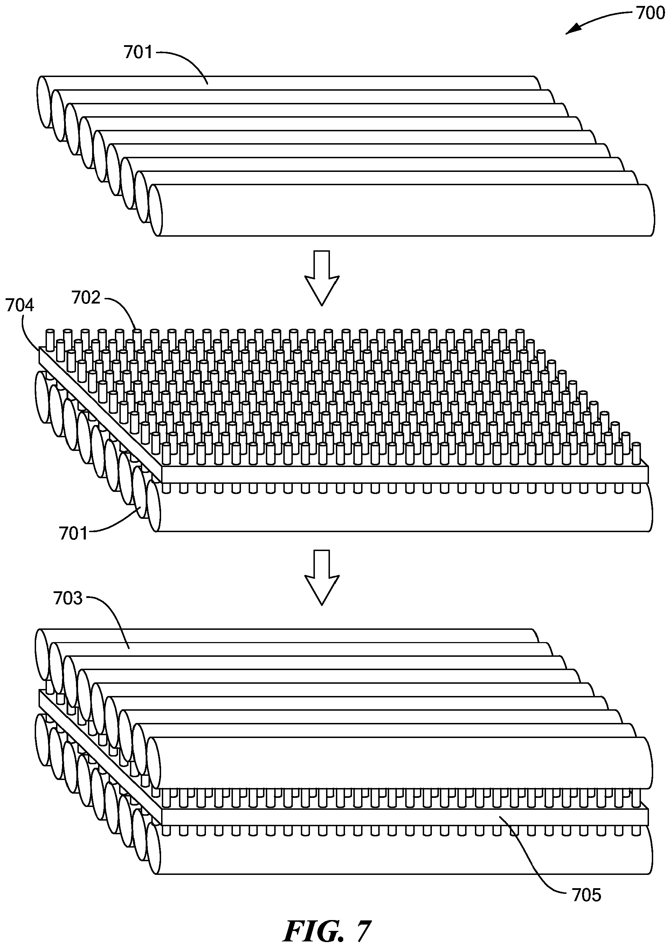

Fig. 7 is a depiction of a process 700 for fabricating a composite structure. A nanostructure array 702 with resin matrix 704, which may be implemented collectively as composite 100 (Fig. 1), composite 200 (Fig. 2), composite 300 (Fig. 3) or composite 400 (Fig. 4), as examples, is placed on top of a fiber layer 701, which may or may not include impregnated resin. Another layer of fibers 703, with or without impregnated resin, is placed on top nanostructure array 702 with resin matrix 704. The fibers could be in any direction in any layer with any size or type including alumina fibers, glass fibers or carbon fibers.

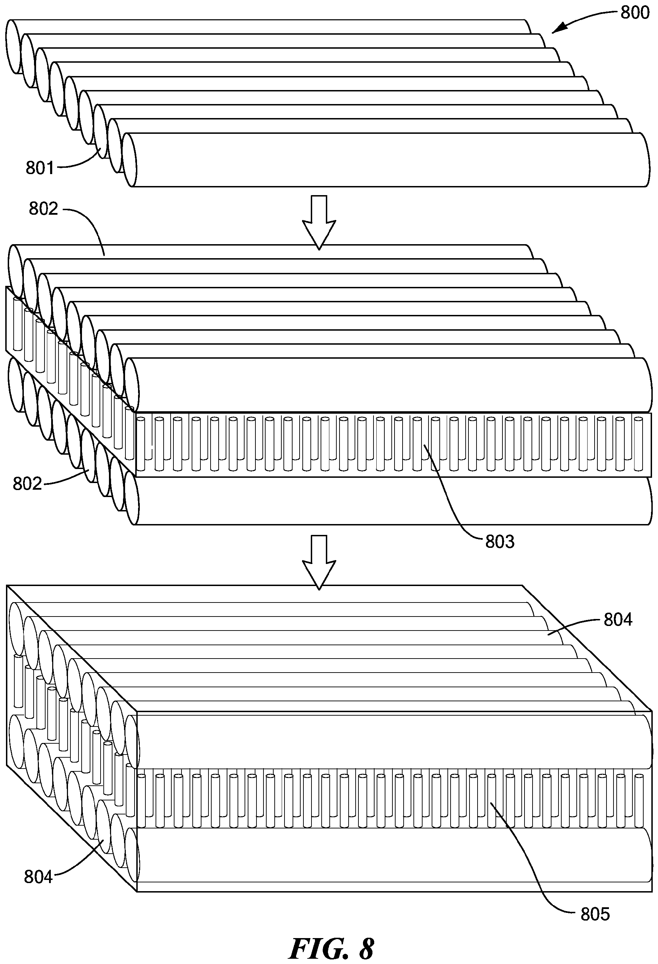

Fig. 8 is a depiction of a process 800 for fabricating a composite structure. A composite 803 composed of a nanostructure array with resin matrix, which may be implemented as composite 500 (Fig. 5) is placed on top of a fiber layer 802, which is without impregnated resin. Another fiber layer 802 without impregnated resin is placed on top of composite 803. At least some of the resin matrix in composite 803 transfers to fiber layers 802 during curing, forming fiber layers with resin matrix 804. The fibers in fiber layers 802 can be in any direction in any layer with any size or type including alumina fibers, glass fibers or carbon fibers.

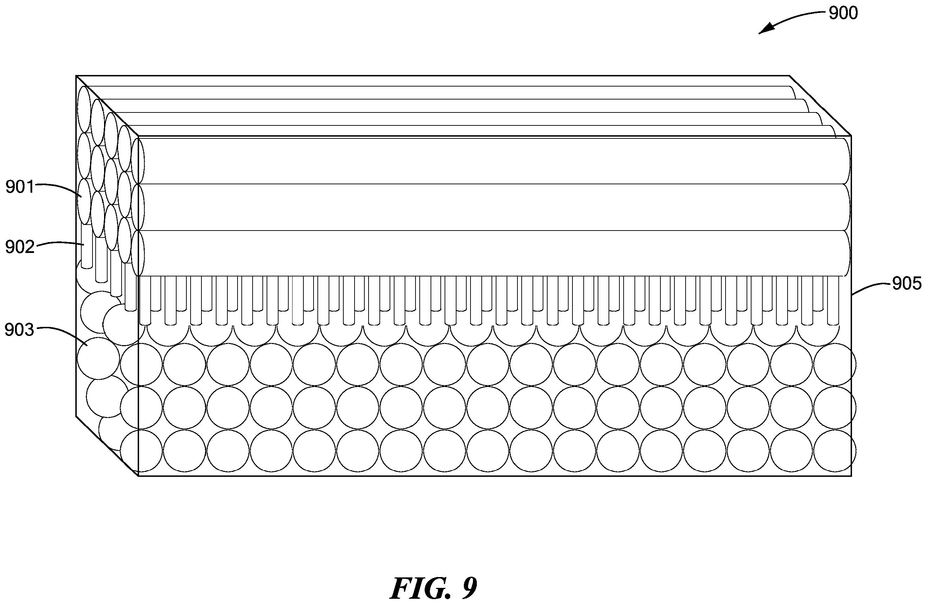

Fig. 9 is a view of a composite 900 comprised of a resin matrix form 905 entirely encapsulating a nanostructure array 902. Resin matrix form 905 is at least 100% of the height, and covers at least one end of the nanostructures in nanostructure array 902. Nanostructure array 902 is between 1 micrometer (micron) and 1000 micrometers (microns) in height and is embedded into two sheets of pre-impregnated layers of fibers 901 and 903 otherwise known as pre-preg.

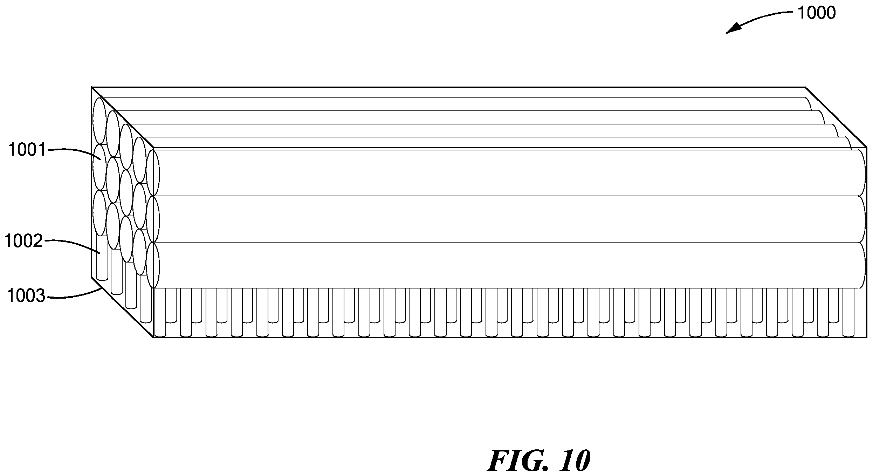

Fig. 10 is a view of a composite 1000 comprised of a resin matrix form 1003 entirely encapsulating a nanostructure array 1002. Resin matrix form 1003 is at least 100% of the height, and covers at least one end of the nanostructures in nanostructure array 1002. Nanostructure array 1002 is between 1 micrometer (micron) and 100 micrometers (microns) in height and is embedded into one sheet of pre-impregnated layer of fibers 1001 otherwise known as pre-preg.

Although Figs. 1-10 illustrate certain examples of implementations or techniques, it should be understood that other variations are included within the scope of the disclosed products, articles or processes. For example, while Figs. 1-10 show a generally planar geometry for the resin matrix and the nanostructure array, other variations are understood to be contemplated. The resin matrix and/or the nanostructure array may be provided with a height gradient, for example, or other geometries that can be specified in accordance with a desired application. In such examples, some nanostructures in an array may be free of the resin matrix and/or be partially covered within the resin matrix and/or have one or both ends covered by the resin matrix and/or be wholly covered by the resin matrix.

Other examples and implementations are within the scope defined by the appended claims. Features implementing functions may also be physically located at various positions, including being distributed such that portions of functions are implemented at different physical locations. Also, as used herein, including in the claims, "or" as used in a list of items prefaced by "at least one of' indicates a disjunctive list such that, for example, a list of "at least one of A, B, or C" means A or B or C or AB or AC or BC or ABC (i.e., A and B and C), or combinations with more than one feature (e.g., AA, AAB, ABBC, etc.).

As used herein, including in the claims, unless otherwise stated, a statement that a function or operation is "based on" an item or condition means that the function or operation is based on the stated item or condition and may be based on one or more items and/or conditions in addition to the stated item or condition. The methods, systems, products and articles discussed above are examples. Various configurations may omit, substitute, or add various procedures or components as appropriate. For instance, in alternative configurations, the methods may be performed in an order different from that described, and that various steps may be added, omitted, or combined. Also, features described with respect to certain configurations may be combined in various other configurations. Different aspects and elements of the configurations may be combined in a similar manner. Also, technology evolves and, thus, many of the elements are examples and do not limit the scope of the disclosure or claims.

Specific details are given in the description to provide a thorough understanding of example configurations (including implementations). However, configurations may be practiced without these specific details. For example, well-known processes, structures, products, articles and techniques have been shown without unnecessary detail to avoid obscuring the configurations. This description provides example configurations only, and does not limit the scope, applicability, or configurations of the claims. Rather, the preceding description of the configurations provides a description for implementing described techniques. Various changes may be made in the function and arrangement of elements without departing from the scope defined by the appended claims.

Also, configurations may be described as a process which is depicted as a flow diagram or block diagram. Although each may describe the operations as a sequential process, some of the operations may be performed in parallel or concurrently. In addition, the order of the operations may be rearranged. A process may have additional stages or functions not included in the figure.

Having described several example configurations, various modifications, alternative constructions, and equivalents may be used. For example, the above elements may be components of a larger system, wherein other techniques may take precedence over or otherwise modify the application of the invention. Also, a number of operations may be undertaken before, during, or after the above elements are considered. Accordingly, the above description does not bound the scope of the claims.

## Claims

1. A method of producing a material, comprising:
providing a nanostructure array, at least some of which nanostructures have a length of at least 1 micrometer (micron), with the long axes of the nanostructures being aligned relative to each other, and a density of at least 10⁸/cm²;
providing the nanostructure array with a resin matrix comprising a polymeric material to form an aligned nanostructure resin film, wherein the resin matrix has a thickness that deviates from a height of the nanostructure array between 1% and 1000%;
connecting a fiber ply to the aligned nanostructure resin film;
applying a resin infusion process to the connected fiber ply and aligned nanostructure resin film; **characterized by**
maintaining the position and alignment of the nanostructures relative to each other with the resin matrix during the resin infusion process;
connecting said nanostructure array to a power supply and using said nanostructure array as electrical resistance heaters to assist the resin curing reaction; and
heating the resin matrix to assist adhesion between the resin matrix and nanostructure array.

2. A method as in any preceding method claim, comprising:
fabricating a composite with a nanostructure array in a resin matrix, where the nanostructures are aligned and maintained in position and alignment relative to each other with the resin matrix during the infusion process, by placing the nanostructure array with the resin matrix in alternating layers with a sequence of fiber layers.

3. A method as in any preceding method claim, wherein the nanostructure array penetrates one or more of the abutting fiber layers above or below, so as to fix or anchor the position and alignment of the nanostructures.

4. The method according to claim 2 or claim 3, wherein the composite assembly is heated at high temperature to form a ceramic material and/or heated in a reducing atmosphere to form a graphitic structure in a carbon-carbon composite.

5. A method as in any preceding method claim, wherein the resin matrix includes one or more of a nano-particle that enhances the conductivity of resin matrix, a conducting polymer, an insulating polymer, a self-healing agent, a ceramic precursor, a ceramic material or a precursor to a graphite as in a carbon-carbon composite.

6. A method as in any preceding method claim, wherein the resin matrix comprises a polythiophene, a polypyrrole, a polyacetylene, a polyphenylene, poly(3,4-ethylenedioxythiophene) (PEDOT), poly(thiophene-3-acetic acid) (PTAA), or copolymers thereof.

7. A method according to claim 1 through 5, wherein the resin matrix comprises at least one of poly(tetrafluoroethylene) (TEFLON®), poly(glycidyl methacrylate), poly(maleic anhydride-alt-styrene), poly[ maleic anhydride-co-dimethyl acrylamide-co-di(ethylene glycol) divinyl ether], poly(furfuryl methacrylate), poly(vinyl pyrrolidone), poly(para- xylylene), poly(dimethylaminomethyl styrene), poly(propargyl methacrylate), poly(methacrylic acid-co-ethyl acrylate), poly(perfluoroalkyl ethyl methacrylate), poly(perfluorodecyl acrylate), poly(trivinyltrimethoxycyclotrisiloxane), poly(furfuryl methacrylate), poly(cyclohexyl methacryateco-ethylene glycol dimethacrylate), poly(pentafluorophenyl methacrylate), poly(pentafluorophenyl methacrylate co-ethylene glycol diacrylate), poly(methacrylic acid-co-ethylene glycol dimethacrylate), poly(methyl methacrylate), poly(3,4-ethylenedioxythiophene), epoxides, phenolics, polyesters, polyurethanes, bis-maleimides, polyimides and silicones.

8. A method as in any preceding method claim, wherein the resin matrix comprises one or more of a B-stage resin or partially cured resin, a hardener, cross-linking agent, coefficient of thermal expansion matching agent, erosion resistance agent, toughener, accelerator, or flame retardant.

9. A method as in any preceding method claim, wherein a volume fraction of the nanostructures within the article is at least between 0.1% and 78% and/or the nanostructures have an average diameter between 1 nm and 100 nm.

10. A method as in any preceding method claim, wherein the resin matrix comprises a material that chemically reacts to form liquid or gaseous species that dissolves in or is removed from the final cured composite.

11. A method as in any preceding method claim, comprising associating at least one backing or release material with the nanostructure array that is not removed and contains a polymer that is used in the composite.

12. The method according to claim 11, wherein the backing or release material comprises a monomer, a polymer, a fiber, or a metal.

13. A method as in claim 11 or 12, wherein the nanostructure array is arranged on a substrate, pre-preg, or semi-preg.

14. A method as in any preceding method claim, wherein providing a nanostructure array comprises: growing or placing a nanostructure array on a surface of a substrate, particularly a fiber layer, wherein the long axes of the nanostructures are substantially aligned and non-parallel to the substrate surface, to form an assembly of nanostructures having a thickness defined by the long axes of the nanostructures.

15. A method as in any preceding method claim, wherein the nanostructures comprise carbon-based nanostructures, in particular carbon nanotubes.

## Patentansprüche

1. Verfahren zur Herstellung eines Materials, umfassend:
Bereitstellen eines Nanostrukturarrays, wobei mindestens einige der Nanostrukturen eine Länge von mindestens 1 Mikrometer (Mikron), mit den langen Achsen der Nanostrukturen, die in Bezug zueinander ausgerichtet sind, und eine Dichte von mindesten 10⁸/cm² aufweisen;
Bereitstellen des Nanostrukturarrays mit einer Harzmatrix, die ein Polymermaterial zur Bildung eines ausgerichteten Nanostrukturharzfilms umfasst, wobei die Harzmatrix eine Dicke aufweist, die von einer Höhe des Nanostrukturarrays zwischen 1 % und 1000 % abweicht;
Verbinden einer Faserlage mit dem ausgerichteten Nanostrukturharzfilm;
Anwenden eines Harzinfusionsprozesses auf die verbundene Faserlage und den ausgerichteten Nanostrukturharzfilm; **gekennzeichnet durch**
Halten der Position und Ausrichten der Nanostrukturen in Bezug zueinander mit der Harzmatrix während des Harzinfusionsprozesses;
Verbinden des Nanostrukturarrays mit einer Stromversorgung und Verwenden des Nanostrukturarrays als elektrische Widerstandsheizer zur Unterstützung der Harzaushärtereaktion; und
Erhitzen der Harzmatrix zur Unterstützung der Haftung zwischen der Harzmatrix und dem Nanostrukturarray.

2. Verfahren nach einem vorstehenden Anspruch, umfassend: Produzieren eines Verbundstoffes mit einem Nanostrukturarray in einer Harzmatrix, wobei die Nanostruktukturen während des Infusionsprozesses in Bezug zueinander ausgerichtet und in Position und Ausrichtung mit der Harzmatrix gehalten werden, indem das Nanostrukturarray mit der Harzmatrix in abwechselnden Schichten mit einer Aufeinanderfolge von Faserschichten platziert wird.

3. Verfahren nach einem vorstehenden Anspruch, wobei das Nanostrukturarray in eine oder mehrere angrenzende Faserschichten oberhalb oder unterhalb eindringt, um die Position und die Ausrichtung der Nanostrukturen zu festigen oder zu verankern.

4. Verfahren nach Anspruch 2 oder Anspruch 3, wobei die Verbundstoffanordnung auf eine hohe Temperatur erhitzt wird, um ein Keramikmaterial zu bilden, und/oder in einer reduzierenden Atmosphäre erhitzt wird, um eine Grafitstruktur in einem Kohlenstoff-Kohlenstoff-Verbundstoff zu bilden.

5. Verfahren nach einem vorstehenden Anspruch, wobei die Harzmatrix eines oder mehr von einem Nanoteilchen, das die Leitfähigkeit der Harzmatrix verbessert, einem leitfähigen Polymer, einem isolierenden Polymer, einem selbsterwärmenden Mittel, einem Keramikvorläufer, einem Keramikmaterial oder einem Vorläufer für ein Grafit, wie im Kohlenstoff-Kohlenstoff-Verbundstoff beinhaltet.

6. Verfahren nach einem vorstehenden Anspruch, wobei die Harzmatrix Polytiophene, Polypyrrol, Polyacetylen, Polyphenylen, Poly(3,4-Ethylendioxytiophene) (PEDOT), Poly(Tiophen-3-Essigsäure) (PTAA) oder Copolymere davon umfasst.

7. Verfahren nach Anspruch 1 bis 5, wobei die Harzmatrix mindestens eines umfasst von Poly(Tetrafluorethylen) (TEFLON®), Poly(Glycidylmethacrylat), Poly(Maleinanhydrid-alt-Styrol), Poly[Maleinanhydrid-co-Dimehtylacrylamid-co-di(Ethylenglykol)Divinylether], Poly(Furfurylmetacrylat), Poly(Vinylpyrrolidin), Poly(Para-Xylylen), Poly(Dimethylaminomethylstyrol), Poly(Propagylmethacrylat), Poly(Methacrylsäure-co-Ethylacrylat), Poly(Perfluoralkyl-ethyl-methacrylat), Poly(Perfluordecylacrylat), Poly(trivinyltrimethoxycyclotrisiloxan), Poly(furfurylmehtacrylat), Poly(Cyclohexylmethacryateco-Ethylenglykoldimethacrylat), Poly(Pentafluorphenylmethacrylat), Poly(Pentafluorphenylmethacrylat-Co-Ethylenglykoldiacrylat), Poly(Methacrylsäure-Co-Ethylenglykoldimethacrylat), Poly(Methylmethacrylat), Poly(3,4-Ethylendioxythiophen), Epoxide, Phenole, Polyester, Polyurethane, Bismaleimide, Polyimide und Silikone.

8. Verfahren nach einem vorstehenden Anspruch, wobei die Harzmatrix eines oder mehr von einem B-Stufenharz oder einem teilweise ausgehärteten Harz, einem Härtemittel, einem Vernetzungsmittel, einem Koeffizienten eines Wärmeausdehnungsabgleichsmittels, einem Erosionsbeständigkeitsmittel, einem Schlagfestmacher, einem Beschleuniger, oder einem Flammenverzögerer umfasst.

9. Verfahren nach einem vorstehenden Anspruch, wobei eine Volumenfraktion der Nanostrukturen innerhalb des Artikels mindestens zwischen 0,1 % und 78 % liegt, und/oder die Nanostrukturen einen mittleren Durchmesser zwischen 1 nm und 100 nm aufweisen.

10. Verfahren nach einem vorstehenden Anspruch, wobei die Harzmatrix ein Material umfasst, das chemisch reagiert, um flüssige oder gasförmige Spezies zu bilden, die sich in einem endgültigen ausgehärteten Verbundstoff auflöst oder daraus entfernt wird.

11. Verfahren nach einem vorstehenden Anspruch, das Zuordnen von mindestens einem Träger- oder Freigabematerial mit dem Nanostrukturarray umfassend, das nicht entfernt wird, und ein Polymer enthält, das in dem Verbundstoff verwendet wird.

12. Verfahren nach Anspruch 11, wobei das Träger- oder Freigabematerial ein Monomer, ein Polymer, eine Faser oder ein Metall umfasst.

13. Verfahren nach Anspruch 11 oder 12, wobei das Nanostrukturarray auf einem Substrat, Preg-Preg oder Semi-Preg angeordnet ist.

14. Verfahren nach einem vorstehenden Anspruch, wobei das Bereitstellen eines Nanostrukturarrays umfasst: Züchten oder Platzieren eines Nanostrukturarrays auf einer Oberfläche eines Substrats, insbesondere einer Faserschicht, wobei die langen Achsen der Nanostrukturen im Wesentlichen ausgerichtet und nicht parallel zur Substratoberfläche sind, um eine Anordnung von Nanostrukturen zu bilden, die eine Dicke aufweisen, die durch die langen Achsen der Nanostrukturen definiert ist.

15. Verfahren nach einem vorstehenden Anspruch, wobei die Nanostrukturen kohlenstoffbasierte Nanostrukturen, inbesondere Kohlenstoff-Nanoröhrchen umfassen.

## Revendications

1. Procédé de production d'un matériau, comprenant :
la fourniture d'un réseau de nanostructures, au moins certaines de ces nanostructures présentant une longueur d'au moins 1 micromètre (micron), les axes longs des nanostructures étant alignés les uns par rapport aux autres, et une densité d'au moins 10⁸/cm²;
la fourniture du réseau de nanostructures avec une matrice de résine comprenant un matériau polymère pour former un film de résine à nanostructures alignées, dans lequel la matrice de résine présente une épaisseur qui s'écarte d'une hauteur du réseau de nanostructures entre 1 % et 1000 % ;
la liaison d'un pli de fibre au film de résine à nanostructures alignées ;
l'application d'un processus d'infusion de résine au pli de fibre et au film de résine à nanostructures alignées reliés ; **caractérisé par**
le maintien de la position et de l'alignement des nanostructures les unes par rapport aux autres avec la matrice de résine durant le processus d'infusion de résine ;
la liaison dudit réseau de nanostructures à une alimentation électrique et l'utilisation dudit réseau de nanostructures en tant qu'éléments chauffants de résistance électrique pour faciliter la réaction de durcissement de résine ; et
le chauffage de la matrice de résine pour faciliter l'adhérence entre la matrice de résine et le réseau de nanostructures.

2. Procédé selon une quelconque revendication précédente, comprenant :
la fabrication d'un composite avec un réseau de nanostructures dans une matrice de résine, où les nanostructures sont alignées et maintenues en position et en alignement les unes par rapport aux autres avec la matrice de résine durant le processus d'infusion, en plaçant le réseau de nanostructures avec la matrice de résine dans des couches en alternance avec une séquence de couches de fibres.

3. Procédé selon une quelconque revendication précédente, dans lequel le réseau de nanostructures pénètre une ou plusieurs des couches de fibres contiguës au-dessus ou au-dessous, de manière à fixer ou ancrer la position et l'alignement des nanostructures.

4. Procédé selon la revendication 2 ou la revendication 3, dans lequel l'ensemble composite est chauffé à une température élevée pour former un matériau céramique et/ou chauffé dans une atmosphère de réduction pour former une structure graphitique dans un composite carbone-carbone.

5. Procédé selon une quelconque revendication précédente, dans lequel la matrice de résine comporte un ou plusieurs parmi une nanoparticule qui améliore la conductibilité de matrice de résine, un polymère conducteur, un polymère isolant, un agent d'auto-cicatrisation, un précurseur céramique, un matériau céramique ou un précurseur à un graphite comme dans un composite carbone-carbone.

6. Procédé selon une quelconque revendication précédente, dans lequel la matrice de résine comprend un polythiophène, un polypyrrole, un polyacétylène, un polyphénylène, du poly(3,4-éthylènedioxythiophène) (PEDOT), du poly(thiophène-3-acide acétique) (PTAA), ou des copolymères de ceux-ci.

7. Procédé selon la revendication 1 à 5, dans lequel la matrice de résine comprend au moins un parmi du poly(tétrafluoroéthylène) (TEFLON®), du poly(méthacrylate de glycidyle), du poly(anhydride maléique-alt-styrène), du poly[anhydride maléique-co-acrylamide diméthylique-co-di(éthylène glycol) divinyle éther], du poly(méthacrylate de furfuryle), du poly(pyrrolidone de vinyle), du poly(para-xylylène), du poly(diméthylaminométhyle styrène), du poly(méthacrylate de propargyle), du poly(acide méthacrylique-co-acrylate d'éthyle), du poly(méthacrylate d'éthyle perfluoroalkyle), du poly(acrylate de perfluorodécyle), du poly(trivinyltriméthoxycyclotrisiloxane), du poly(méthacrylate de furfuryle), du poly(méthacrylate de cyclohexyle-co-diméthacrylate d'éthylène glycol), du poly(méthacrylate de pentafluorophényle), du poly(méthacrylate de pentafluorophényle co-diacrylate d'éthylène glycol), du poly(acide méthacrylique-co-diméthacrylate d'éthylène glycol), du poly(méthacrylate de méthyle), du poly(3,4-éthylènedioxythiophène), des époxydes, des phénoliques, des polyesters, des polyuréthanes, des bis-maléimides, des polyimides et des silicones.

8. Procédé selon une quelconque revendication précédente, dans lequel la matrice de résine comprend un ou plusieurs parmi une résine de stade B ou résine partiellement durcie, un durcisseur, un agent de réticulation, un agent d'adaptation de coefficient de dilatation thermique, un agent de résistance à l'érosion, un solidifiant, un accélérateur, ou un ignifugeant.

9. Procédé selon une quelconque revendication précédente, dans lequel une fraction en volume des nanostructures dans l'article est au moins entre 0,1 % et 78 % et/ou les nanostructures présentent un diamètre moyen entre 1 nm et 100 nm.

10. Procédé selon une quelconque revendication précédente, dans lequel la matrice de résine comprend un matériau qui réagit chimiquement pour former une espèce liquide ou gazeuse qui se dissout dans le composite durci final ou est retirée de celui-ci.

11. Procédé selon une quelconque revendication précédente, comprenant l'association d'au moins un matériau de support ou de libération avec le réseau de nanostructures qui n'est pas retiré et contient un polymère qui est utilisé dans le composite.

12. Procédé selon la revendication 11, dans lequel le matériau de support ou de libération comprend un monomère, un polymère, une fibre ou un métal.

13. Procédé selon la revendication 11 ou 12, dans lequel le réseau de nanostructures est agencé sur un substrat, un pré-imprégné ou un semi-imprégné.

14. Procédé selon une quelconque revendication précédente, dans lequel la fourniture d'un réseau de nanostructures comprend : la croissance ou le placement d'un réseau de nanostructures sur une surface d'un substrat, en particulier une couche de fibres, dans lequel les axes longs des nanostructures sont sensiblement alignés et non parallèles à la surface de substrat, pour former un ensemble de nanostructures présentant une épaisseur définie par les axes longs des nanostructures.

15. Procédé selon une quelconque revendication précédente, dans lequel les nanostructures comprennent des nanostructures à base de carbone, en particulier des nanotubes de carbone.
